Europäisches Patentamt

European Patent Office

Office européen des brevets

(11) Veröffentlichungsnummer: **0 513 610 A1**

## (12) EUROPÄISCHE PATENTANMELDUNG

(21) Anmeldenummer: **92107503.2**

(22) Anmeldetag: **04.05.92**

(51) Int. Cl.5: **H05K 13/00**, B65G 47/90

(30) Priorität: **17.05.91 DE 4116289**

(43) Veröffentlichungstag der Anmeldung:
**19.11.92 Patentblatt 92/47**

(84) Benannte Vertragsstaaten:
**AT BE CH DE GB IT LI**

(71) Anmelder: **SIEMENS AKTIENGESELLSCHAFT**
**Wittelsbacherplatz 2**
**W-8000 München 2(DE)**

(72) Erfinder: **Kaiser, Mathias**
**Waldstrasse 2**
**W-7527 Kraichtal/BA(DE)**
Erfinder: **Rittler, Horst**
**Steinacker 4**
**W-7526 Ubstadt-Weiher(DE)**

(54) **Vorrichtung zum Handhaben von Leiterplatten.**

(57) Die Vorrichtung weist eine waagerechte flache Auflageplatte (4) auf, auf die die Leiterplatten (1) rutschhemmend aufgelegt werden können. Die Auflageplatte (4) ist in waagerechter und senkrechter Richtung bewegbar, so daß die Leiterplatten (1) in verschiedenen übereinanderliegenden Ebenen abgeholt bzw. abgelegt werden können.

FIG1

EP 0 513 610 A1

Die Erfindung bezieht sich auf eine Vorrichtung zum Handhaben von bestückten oder unbestückten elektrischen Leiterplatten mit einer Halteeinrichtung für die Leiterplatten, wobei die Halteeinrichtung durch eine roboterartige Antriebseinheit zumindest in senkrechter und waagerechter Richtung bewegbar ist.

Durch die EP 0 047 938 A2 ist ein Roboter zum Handhaben von Teilen bekannt geworden, dessen Roboterarm um eine senkrechte Achse schwenkbar und senkrecht verfahrbar ist. Am Roboterarm ist ein Greifer befestigt, der in waagerechter Richtung bewegbar gelagert ist.

Durch das deutsche Gebrauchsmuster 88 09 713 ist ferner ein Greifer für Leiterplatten bekannt geworden, der die Leiterplatten mit gegeneinander verspannbaren Greiffingern an ihren Rändern erfassen kann. Es ist üblich, z. B. waagerecht auf einem Transportband aufliegende bestückte oder unbestückte Leiterplatten mittels eines Greifers von oben her zu erfassen und z. B. einer Bestückungs oder Prüfeinrichtung zuzuführen. Durch die Spannkräfte kann es insbesondere bei großen und relativ dünnen bestückten Leiterplatten zu Verformungen kommen, die zu einer Beschädigung der empfindlichen Bauteile oder elektrischen Verbindungen führen können.

Ferner ist es üblich, für die Leiterplatten Sauggreifer zu verwenden, für die jedoch bei voller Bestückung nicht immer geeignete Greiferflächen zur Verfügung stehen.

Durch das Greifen der flachliegenden Leiterplatte von oben her ist ein Transport in senkrechter Richtung in eine darüber oder darunter liegende Bearbeitungsposition nicht möglich.

Der Erfindung liegt die Aufgabe zugrunde, die Leiterplatte schonend aufnehmen und einfach in mehreren übereinanderliegenden Ebenen ablegen zu können.

Diese Aufgabe wird durch die Erfindung gemäß Anspruch 1 gelöst. Durch die Ausgestaltung der Halteeinrichtung als flache Platte, auf der die Leiterplatte durch ihr Eigengewicht gehalten ist, werden Klemmspannungen beim Greifen vollkommen vermieden. Die Leiterplatte kann auf ihrer gesamten Oberfläche beliebig bestückt werden ohne auf das Freihalten von Saugflächen achten zu müssen. Durch die flache Ausbildung der Halteeinrichtung ist es möglich, die Leiterplatte in mehreren übereinander liegenden Ebenen zu greifen bzw. abzulegen, indem die Halteeinrichtung von der Seite her unter die Leiterplatte geschoben und sodann angehoben wird, worauf sie in eine andere, z. B. darunterliegende Ebene verlagert werden kann. Nach dem Auflegen wird die Auflageplatte zunächst geringfügig nach unten abgesenkt und danach wieder zur Seite herausgezogen.

Vorteilhafte Weiterbildungen der Erfindung sind in den Ansprüchen 2 bis 6 gekennzeichnet:

Durch den rutschfesten Belag nach Anspruch 2 wird die Leiterplatte in einfacher Weise ohne seitliche Anschläge auf der Auflageplatte gehalten. Unterschiedliche Leiterplattenabmessungen erfordern keine unterschiedlichen Auflageplatten. Es ist aber auch möglich, die Auflageplatte mit seitlichen Anschlägen für die Leiterplatten zu versehen. Dies ist insbesondere dann vorteilhaft, wenn überwiegend Leiterplatten gleichen Typs transportiert werden sollen.

Die lineare Bewegung nach Anspruch 3 kann z. B. durch einen waagerechten pneumatischen Linearantrieb verwirklicht werden.

Die Weiterbildung nach Anspruch 4 ermöglicht ebenfalls eine waagerechte Bewegung der Auflageplatte durch Schwenken der Antriebseinheit. In Verbindung mit dem waagerechten Linearantrieb ist es möglich, die Vorrichtung mit drei Freiheitsgraden universell einzusetzen. Beispielsweise können durch die Vorrichtung zwei getrennte, senkrecht zueinander stehende Transportbänder sowie Prüfeinrichtungen und Stapelmagazine bedient werden.

Die Weiterbildungen nach den Ansprüchen 5 und 6 ermöglichen ein einfaches Auflegen der Leiterplatte auf die Zwischenablage, so daß die Auflageplatte ungehindert herausgezogen werden kann. Daraufhin läßt sich die Leiterplatte z. B. auf die Vakuumdichtung einer Prüfeinrichtung absenken. Nach dem Prüfen kann die Leiterplatte wieder angehoben und auf die Halteplatte aufgelegt werden.

Im folgenden wir die Erfindung anhand eines in der Zeichnung dargestellten Ausführungsbeispiels näher erläutert.

Es zeigen:

Fig. 1    schematisiert und perspektivisch eine Vorrichtung zum Handhaben von Leiterplatten, mit Transportbändern und einer Prüfeinrichtung,

Fig. 2    eine teilweise Seitenansicht der Prüfeinrichtung,

Fig. 3    eine teilweise Seitenansicht eines Stapelmagazins für die bestückten Leiterplatten.

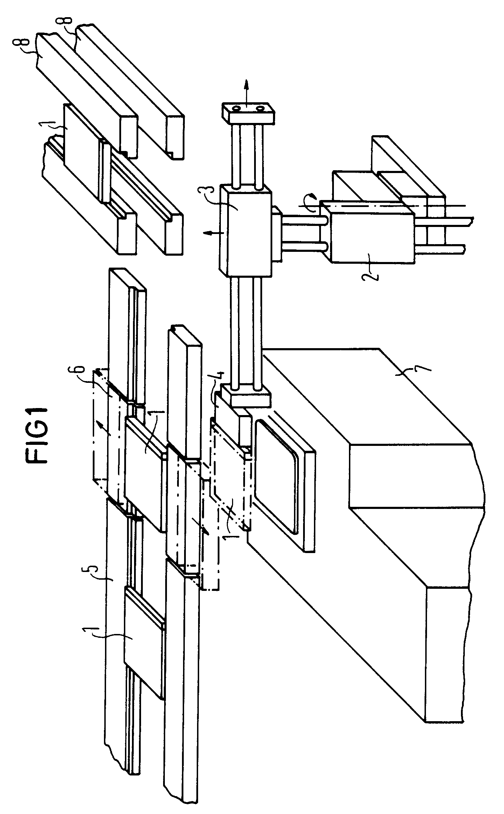

Nach Figur 1 besteht eine Vorrichtung zum Handhaben von elektrischen Leiterplatten 1 aus einer um eine senkrechte Achse schwenkbaren Antriebseinheit 2, einem waagerechten Linearantrieb 3 und einer Auflageplatte 4. Die Antriebseinheit 2 ist um eine senkrechte Achse schwenkbar, der Linearantrieb 3 durch die Antriebseinheit 2 in senkrechter Richtung bewegbar. Die Auflageplatte 4 ist durch den Linearantrieb 3 in waagerechter Richtung verschiebbar. Auf einem ankommenden Transportband 5 werden die Leiterplatten 1 in eine Übergabestation 6 gebracht. Deren beide Teilbänder können seitlich weggezogen werden so daß die Leiterplatte 1 nach unten wegbewegt und auf eine Prüfeinrichtung 7 aufgelegt werden kann. Nach dem Prüfen wird die Leiterplatte 1 durch die Auflageplatte wieder abgehoben und in Richtung zweier übereinanderliegender abgehender Transportbänder 8 geschwenkt. Dabei dient das obere der beiden abgehenden Transportbänder 8 dem Weitertransport der für gut befundenen Leiterplatten und das untere dem Abtransport der fehlerbehafteten. Durch die Antriebseinheit 2 kann die Auflageplatte auf das entsprechende Höhenniveau gebracht werden und durch die Lineareinheit 3 in den Bereich der abgehenden Transportbänder 8 verschoben werden.

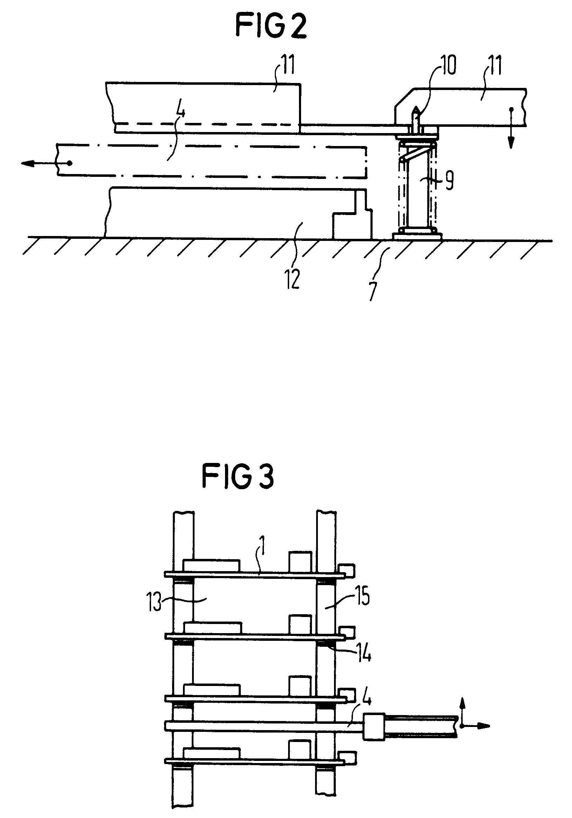

Figur 2 zeigt eine über dem Prüfadapter angeordnete Zwischenablage 9, die federnd gelagerte Positionierstifte 10 aufweist. Die bestückte Leiterplatte 1 wird durch die Auflageplatte 4 zunächst auf die Zwischenablage 9 aufgelegt, wobei die Positionierstifte 10 in entsprechende Positionierbohrungen der Leiterplatte 1 eingreifen. Nach dem seitlichen Herausziehen der Auflageplatte 4 kann die Leiterplatte 1 mittels seitlicher Druckarme 11 gegen den Federdruck der Zwischenablage 9 auf eine Vakuumdichtung 12 der Prüfeinrichtung 7 abgesenkt und daraufhin geprüft werden.

Nach Figur 3 weist ein Stapelmagazin 13 für die Leiterplatten 1 mehrere übereinanderliegende Auflageschultern 14 auf, die an senkrechten Trägern 15 des Stapelmagazins 13 angebracht sind. Der Abstand zwischen den Stapelebenen ist so groß, daß die Auflageplatte 4 zwischen die einzelnen Leiterplatten 1 eingeschoben werden kann. Durch die senkrechte Bewegbarkeit der Halteplatte ist es möglich, diese auf verschiedene Höhen einzustellen.

**Patentansprüche**

1. Vorrichtung zum Handhaben von bestückten oder unbestückten elektrischen Leiterplatten (1) mit einer Halteeinrichtung für die Leiterplatten, wobei die Halteeinrichtung durch eine roboterartige Antriebseinheit zumindest in senkrechter und waagerechter Richtung bewegbar ist,
   **dadurch gekennzeichnet,**
   daß die Halteeinrichtung als waagerechte flache Auflageplatte (4) ausgebildet ist, die Mittel zur seitlichen Fixierung der Leiterplatte (1) aufweist.

2. Vorrichtung nach Anspruch 1,
   **dadurch gekennzeichnet,**
   daß die Auflageplatte (4) mit einem rutschhemmenden Belag versehen ist.

3. Vorrichtung nach Anspruch 1 oder 2,
   **dadurch gekennzeichnet,**
   daß die Auflageplatte (4) in waagerechter Richtung linear bewegbar ist.

4. Vorrichtung nach Anspruch 1, 2 oder 3,
   **dadurch gekennzeichnet,**
   daß die Antriebseinheit (2) um eine senkrechte Achse schwenkbar ist.

5. Vorrichtung nach einem der vorhergehenden Ansprüche,
   **dadurch gekennzeichnet,**
   daß über einer Bearbeitungs- oder Prüfeinrichtung (7) eine Zwischenablage (9) vorgesehen ist, auf die die Leiterplatte (1) von der Auflageplatte (4) auflegbar ist und von der die Leiterplatte (1) nach dem Entfernen der Auflageplatte (4) in eine Prüf- bzw. Bearbeitungsstellung absenkbar ist.

6. Vorrichtung nach Anspruch 5,
   **dadurch gekennzeichnet,**
   daß die Zwischenablage (9) absenkbare Positionierstifte (10) aufweist.

FIG1

EP 0 513 610 A1

# FIG 2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | DE-A-3 539 723 (WEBER) <br> * das ganze Dokument * <br> --- | 1,3,4 | H05K13/00 <br> B65G47/90 |
| Y | EP-A-0 285 239 (VARIAN) <br> * Spalte 2, Zeile 29 - Spalte 4, Zeile 23; Abbildungen 1,2B * <br> --- | 1,3,4 | |
| A | WO-A-8 809 246 (AERONCA) <br> * Seite 5, Zeile 1 - Seite 13, Zeile 3; Ansprüche 1,14; Abbildungen 1-6 * <br> --- | 1,3,4 | |
| D,A | EP-A-0 047 938 (FUJITSU) <br> --- | 1 | |
| D,A | DE-U-8 809 713 (SIEMENS AKTIENGESELLSCHAFT) <br><br> ----- | 1 | |
| | | | **RECHERCHIERTE SACHGEBIETE (Int. Cl.5)** <br><br> H05K <br> H01L <br> B65G <br> B25J |

Der vorliegende Recherchenbericht wurde für alle Patentansprüche erstellt

| Recherchenort | Abschlußdatum der Recherche | Prüfer |
|---|---|---|
| DEN HAAG | 25 AUGUST 1992 | RIEUTORT A.S. |